# EUROPÄISCHE PATENTSCHRIFT

(11) **EP 0 892 496 B1**
(45) Veröffentlichungstag und Bekanntmachung des Hinweises auf die Patenterteilung: **26.10.2005**
(21) Anmeldenummer: 98104969.5
(22) Anmeldetag: 19.03.1998
(51) Int. Cl.: H03J 1/00

(54) **Autoradio und Verfahren zur Überprüfung und/oder Aktualisierung einer abgespeicherten Sendertabelle eines Autoradios**
Car radio receiver and method for checking and /or updating a stored frequency table of a car radio
Autoradio et méthode de vérification et/ou de mise à jour d' une tabelle de fréquence enregistrée dans une autoradio

(30) Priorität: 14.07.1997 DE 19730050
(43) Veröffentlichungstag der Anmeldung: 20.01.1999
(73) Patentinhaber: ROBERT BOSCH GMBH, 70442 Stuttgart (DE)
(72) Erfinder: Rychlak, Stefan, 31241 Ilsede (DE)

(56) Entgegenhaltungen:
- DE-A- 4 318 867
- DE-A- 19 520 635
- PATENT ABSTRACTS OF JAPAN vol. 012, no. 123 (P-690), 16. April 1988 & JP 62 248191 A (ALPINE ELECTRON INC), 29. Oktober 1987

## Beschreibung

Die Erfindung betrifft ein Verfahren zur Überprüfung und/oder Aktualisierung einer abgespeicherten Sendertabelle eines Autoradios, bei dem von den Rundfunkanstalten innerhalb der Rundfunksignale kodiert ausgestrahlte Senderinformationen empfangen und dekodiert werden und mehrere zu einer Senderstation gehörende Sendefrequenzen in einem Speicher abgelegt werden. Die Erfindung betrifft ferner ein Autoradio mit einer abstimmbaren Empfängerstufe und einer auf die Empfängerstufe oder alternative Audioquellen umschaltbaren Audiostufe sowie einer Steuerung und einer Dekodierstufe für Senderinformationen, an die ein Speicher für verschiedene, zu einer Senderstation gehörenden Sendefrequenzen angeschlossen ist.

Die Übertragung von kodierten Senderinformationen innerhalb eines Rundfunksignals, wie sie beispielsweise in dem derzeit aktuellen RDS-System erfolgt, ermöglicht die Erkennung einer Senderstation mit Hilfe einer Programmidentifikation innerhalb des Sendersignals, so daß im Autoradio mehrere zu einer Senderstation gehörende, aktuell empfangbare Sendefrequenzen als Alternativfrequenzen abgespeichert werden. Beim Einstellen einer Sendefrequenz einer ausgewählten Senderstation kann das Autoradio überprüfen, ob der Empfang auf einer Alternativfrequenz nicht besser ist und ggf. automatisch eine Umschaltung auf eine besser empfangbare Alternativfrequenz vornehmen. Dabei ist es möglich, in dem Autoradio bereits eine Vorsortierung der Alternativfrequenzen nach der aktuellen Empfangsqualität vorzunehmen. Ein Beispiel einer solcher Verfahen und Autoradio ist in Dokument DE-A-4 318 868 veröffentlicht.

Bewegt sich das Kraftfahrzeug, in das das Autoradio eingebaut ist, ändern sich möglicherweise die zu einer Senderstation gehöre den, empfangbaren Sendefrequenzen. Die entsprechende Information wird im Speicher der Alternativfrequenz für die vom Autoradio gerade empfangene Senderstation aktualisiert. Bleibt das Autoradio mit seinem Empfangsteil während der Fahrt ständig auf die eine Senderstation abgestimmt, weil das Programm dieser Senderstation verfolgt wird oder weil das Autoradio beispielsweise im Kassettenbetrieb oder im CD-Betrieb läuft, wird die Aktualisierung der Alternativfrequenzen über die von dieser Senderstation ausgesandten Senderinformationen nur für die empfangene Senderstation durchgeführt.

Wird das Autoradio vom Benutzer während der Fahrt abgeschaltet, findet eine Anpassung der abgespeicherten Alternativfrequenzen an die neue Landschaft gar nicht statt. Wird in diesem Fall das Autoradio in der neuen Landschaft wieder eingeschaltet, findet ein Suchvorgang für etwaige empfangbare Sendefrequenzen für die angewählte Senderstation nach dem Einschalten statt und stört den ggf. möglichen guten Empfang der Senderstation, da das Autoradio die geeigneteste Sendefrequenz dieser Senderstation nicht kennt.

Das der Erfindung zugrundeliegende Problem besteht darin, daß einerseits eine Anpassung der abgespeicherten Senderinformationen an die neue Landschaft während der Fahrt wünschenswert wäre, andererseits dadurch die Nutzung des Autoradios durch den Benutzer nicht gestört werden soll.

Zur Lösung dieses Problems ist erfindungsgemäß ein Verfahren der eingangs erwähnten Art dadurch gekennzeichnet, daß in einem Zustand des Autoradios, in dem kein Rundfunkprogramm hörbar geschaltet ist, das Autoradio auf verschiedene empfangbare Sendefrequenzen abgestimmt wird und dabei eine Überprüfung der empfangbaren Sendestationen und Zuordnung ihrer verschiedenen Sendefrequenzen vorgenommen wird und ggf. die im Speicher abgelegten Sendefrequenzen erneuert oder neu sortiert werden. Durch das erfindungsgemäße Verfahren wird somit eine Aktualisierung der abgespeicherten Informationen über Alternativfrequenzen einer Senderstation dann vorgenommen, wenn die hierfür erforderliche Überprüfung durch das Autoradio, nämlich durch Abstimmung des Empfängerteils auf verschiedene Empfangsfrequenzen, den Benutzer des Autoradios nicht stört. Dies ist immer dann der Fall, wenn die Audiostufe des Autoradios nicht von der Empfängerstufe des Autoradios versorgt wird, weil das Autoradio insgesamt abgeschaltet ist oder weil über die Audiostufe keine Rundfunksignale sondern von einer anderen Audiosignalquelle gelieferte Audiosignale wiedergegeben werden, also beispielsweise im Kassetten-, CD- oder Telefonierbetrieb des Autoradios.

Demgemäß kann die erfindungsgemäße Überprüfung der empfangbaren Senderstationen im vom Benutzer abgeschalteten Zustand des Autoradios durchgeführt werden. In diesem Fall kann das Autoradio für den Benutzer im abgeschalteten Zustand bleiben, also indem keine Beleuchtung eingeschaltet wird, jedoch eine Wirksamschaltung derjenigen Teile des Autoradios erfolgen, die für die Überprüfung der empfangbaren Senderstationen benötigt werden. Eine derartige Überprüfung kann somit für den Benutzer unbemerkt im Hintergrund ablaufen.

Alternativ oder ergänzend hierzu wird die Überprüfung während der Hörbarkeit einer oben erwähnten alternativen Audioquelle durchgeführt.

Es kann zweckmäßig sein, die Überprüfung grundsätzlich nur dann vorzunehmen, wenn eine vom Fahrzeug erzeugte Versorgungsspannung detektiert wird, wenn also der Fahrzeugmotor läuft, da in aller Regel nur in diesem Fall eine Veränderung der Senderlandschaft für das Autoradio erfolgt. Alternativ oder zusätzlich hierzu kann vorgesehen werden, beim Abschalten einer vom Fahrzeug erzeugten Versorgungsspannung die Überprüfung vorzunehmen, also jedesmal am Ende einer Fahrt die Überprüfung, vorzugsweise im Hintergrund und für den Benutzer unerkannt, ablaufen zu lassen.

Findet die Überprüfung in einem Zustand des Autoradios statt, indem eine alternative Audioquelle hörbar geschaltet ist und ist dabei eine Vorrangschaltung für Verkehrsfunkinformationen der im Empfängerteil eingestellten Senderstation wirksam geschaltet worden, wird die Überprüfung anderer Sendefrequenzen immer nur kurzzeitig unter jeweiligem Zurückspringen auf die ursprünglich eingestellte Sendefrequenz zur Überprüfung der eventuellen Aussendung eines Verkehrsinformationssignals vorgenommen. Dadurch ist sichergestellt, daß durch den Überprüfungsvorgang ein Kennungssignal für eine Verkehrsfunkinformation nicht unbemerkt bleibt. Für die Überprüfung anderer Sendefrequenzen stehen daher immer nur kurze Zeitabschnitte im ms-Bereich zur Verfügung.

Zur Lösung des oben genannten Problems ist erfindungsgemäß ein Autoradio der eingangs erwähnten Art zur Ausführung des erfindungsgemäßen Verfahrens dadurch gekennzeichnet, daß die Steuerung eine Statuserkennung für den Ein- und Ausschaltzustand des Autoradios und eine Statuserkennung für eine Umschaltungseinrichtung zwischen Empfängerstufe und Audiostufe aufweist und daß die Steuerung in Abhängigkeit von den Statuskennungen eine Durchstimmung der Empfängerstufe zur Erkennung empfangbarer Sendefrequenzen und deren Zuordnung zu Senderstationen steuert.

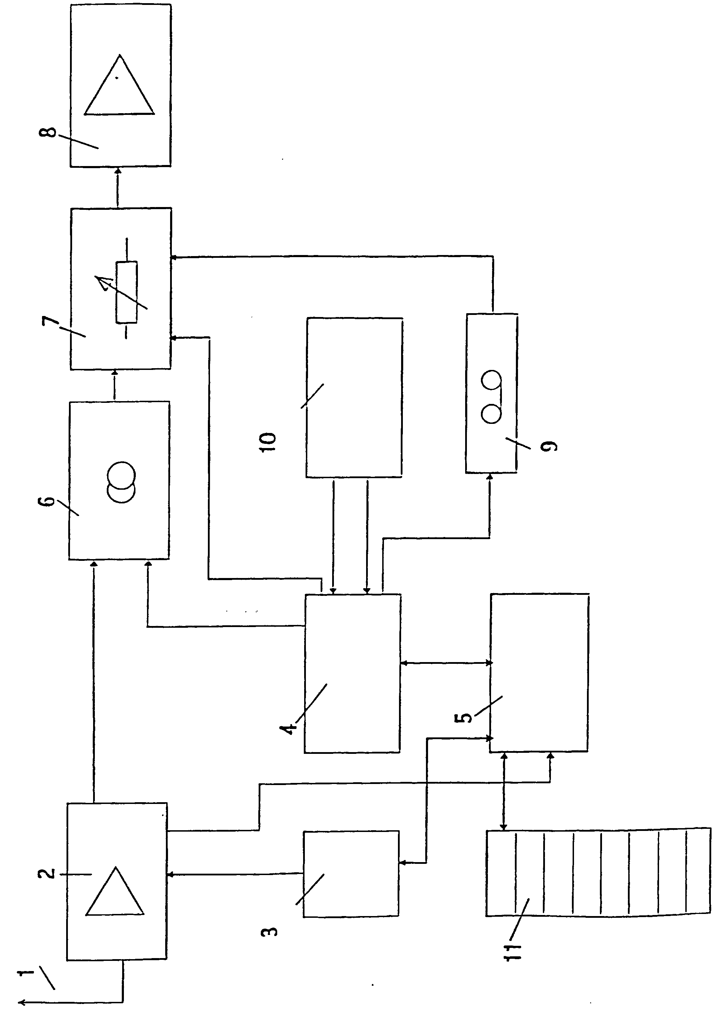

Die Erfindung wird im folgenden anhand eines in der Zeichnung dargestellten Blockschaltbilds eines Autoradios gemäß einer Ausführungsform der Erfindung näher erläutert.

Ein über eine Antenne 1 empfangenes Rundfunksignal gelangt im Autoradio auf eine Empfängerstufe 2, in der das Rundfunksignal verstärkt, mit einem abstimmbaren Mischer auf eine Zwischenfrequenz umgesetzt und schließlich in eine Audiofrequenz transformiert wird. Die Abstimmung der Empfängerstufe 2 erfolgt mit Hilfe einer PLL-Schaltung 3. Die Abstimmung wird gesteuert durch einen zentralen Mikroprozessor 4 des Autoradios, der mit einem RDS-Mikroprozessor 5 für die Dekodierung und Verarbeitung der kodierten Senderinformationen in dem empfangenen Signal zusammenarbeitet. Der RDS-Mikroprozessor 5 steuert die PLL-Schaltung 3. Der zentrale Mikroprozessor 4, der mit (nicht dargestellten) Bedieneinrichtungen verbunden ist, steuert einen Stereodekoder 6, in dem die Signalanteile der beiden Stereokanäle gebildet werden, falls ein Stereoempfang gewünscht wird. Andernfalls steht am Ausgang des Stereodekoder 6 ein Monosignal an. Mit dem Stereodekoder 6 ist eine NF-Einstellstufe 7 verbunden, die einerseits zur Lautstärke- und Klangbeeinflussung des Audiosignals dient und andererseits eine Umschaltstufe beinhaltet, durch die eine nachfolgende Endstufe 8 mit der Empfängerstufe 2 oder mit einer alternativen Audioquelle, hier dargestellt in Form eines Kassettenteils 9 des Autoradios verbindbar ist. Selbstverständlich können durch die Umschaltstufe in der Niederfrequenz-Einstellvorrichtung 7 auch andere Audiosignalquellen, wie CD-Spieler oder Telefon, mit der Endstufe 8 verbunden werden, so daß auch diese Signale über die im Kraftfahrzeug eingebauten Lautsprecher wiedergebbar sind.

Der zentrale Mikroprozessor 4 wird an unterschiedlichen Eingängen entweder durch eine Spannungsversorgungsstufe 10 entweder mit einer Batteriespannung UB oder mit einer vom Fahrzeug erzeugten Betriebsspannung UZ versorgt. Der Versorgungszustand über die Betriebsspannung UB oder die Betriebsspannung UZ wird im Mikroprozessor 4 durch eine entsprechende Statuskennung verfügbar gehalten. Ferner enthält der Mikroprozessor 4 eine Statuskennung für den an den Bedienelementen eingestellten Ein- bzw. Ausschaltzustand des Autoradios.

Im RDS-System enthält das empfangene Rundfunksignal Senderinformationen, die eine Zuordnung des empfangenen Rundfunksignals zu einer Senderstation ermöglichen. Die RDS-Information kann ferner Informationen über Alternativfrequenzen enthalten, die vom RDS-Mikroprozessor 5 ausgewertet werden. Die Verfügbarkeit dieser Informationen ist dadurch gegeben, daß mit dem RDS-Mikroprozessor 5 ein Speicher 11 verbunden ist, in dem für jede Senderstation mögliche Empfangsfrequenzen S1 ... S8 abspeicherbar sind. Wird die RDS-Information über Alternativfrequenzen nicht vom RDS-Mikroprozessor 5 ausgenutzt, kann der RDS-Mikroprozessor 5 beim Durchscannen der Empfangsstufe 2 verschiedene Sendefrequenzen, die zu derselben Programminformation des RDS-Signals gehören, zuordnen und auf Empfangsgüte testen, so daß die Abspeicherung der Frequenzen S1 bis S8 in dem Speicher 11 eine Rangfolge enthält, in der das Radio Alternativfrequenzen auf besseren Empfang überprüft, wenn die eingestellte Sendefrequenz einer Senderstation nicht mehr in bester Qualität empfangen wird. Eine entsprechende Abspeicherung von Alternativfrequenzen S1 bis S8 im Speicher 11 kann vorzugsweise für jede empfangbare Senderstation erfolgen, so daß alle aktuellen Informationen für die jeweilige Landschaft, in der sich das Autoradio befindet, im Speicher 11 abgespeichert sind.

Eine Aktualisierung der im Speicher 11 abgespeicherten Information kann erfolgen, wenn die Statuskennung im zentralen Mikroprozessor 4 ein ausgeschaltetes Autoradio indiziert und/oder wenn die NF-Einstellvorrichtung 7 auf eine alternative Audioquelle, beispielsweise Kassettenteil 9, umgeschaltet ist. Dabei kann es zweckmäßig sein, die Überprüfung durch den zentralen Mikroprozessor 4 in Verbindung mit dem RDS-Mikroprozessor 5 nur dann ablaufen zu lassen, wenn die Statuskennung 4 im zentralen Mikroprozessor eine Spannungsversorgung mit der Spannung UZ anzeigt, da nur in diesem Fall das Kraftfahrzeug aus eigener Kraft bewegt wird und in eine andere Sendelandschaft geraten kann. Ferner kann der zentrale Mikroprozessor 4 eine Überprüfung und Aktualisierung des Inhalts des Speichers 11 veranlassen, wenn die Spannung UZ abgeschaltet wird, also die Fahrt mit dem Kraftfahrzeug beendet worden ist. Ferner ist es möglich, die Überprüfung und Aktualisierung des Inhalts des Speichers 11 vom zentralen Mikroprozessor 4 in vorgegebenen zeitlichen Abständen vornehmen zu lassen, wenn an den Mikroprozessor 4 eine Uhr angeschlossen ist, wobei die Überprüfung nur stattfindet, wenn die Statuskennungen im Mikroprozessor anzeigen, daß eine Überprüfung ohne Störung möglich ist, also wenn das Autoradio abgeschaltet ist oder wenn über die Endstufe 8 Audiosignale gehört werden, die nicht aus der Empfängerstufe 2 stammen.

## Patentansprüche

1. Verfahren zur Überprüfung und/oder Aktualisierung einer abgespeicherten Sendertabelle (S1 ... S8) eines Autoradios, bei dem von den Rundfunkanstalten innerhalb der Rundfunksignale kodiert ausgestrahlte Senderinformationen empfangen und dekodiert werden und mehrere zu einer Senderstation gehörende Sendefrequenzen in einem Speicher (11) abgelegt werden, **dadurch gekennzeichnet, daß** in einem Zustand des Autoradios, in dem kein Rundfunkprogramm hörbar geschaltet ist, das Autoradio auf verschiedene empfangbare Sendefrequenzen abgestimmt wird und dabei eine Überprüfung der empfangbaren Senderstationen und Zuordnung ihrer verschiedenen Sendefrequenzen vorgenommen wird und ggf. die im Speicher (11) abgelegten Sendefrequenzen (S1 ... S8) erneuert oder neu sortiert werden.

2. Verfahren nach Anspruch 1, **dadurch gekennzeichnet, daß** die Überprüfung der empfangbaren Senderstationen im vom Benutzer abgeschalteten Zustand des Autoradios durchgeführt wird.

3. Verfahren nach Anspruch 1 oder 2, **dadurch gekennzeichnet, daß** die Überprüfung der empfangbaren Senderstationen während der Hörbarkeit einer alternativen eigenen Audioquelle (9) durchgeführt wird.

4. Verfahren nach einem der Ansprüche 1 bis 3, **dadurch gekennzeichnet, daß** die Überprüfung voraussetzt, daß eine vom Fahrzeug erzeugte Versorgungsspannung (UZ) detektiert wird.

5. Verfahren nach einem der Ansprüche 1 bis 4, **dadurch gekennzeichnet, daß** beim Abschalten einer vom Fahrzeug erzeugten Versorgungsspannung (UZ) eine Überprüfung vorgenommen wird.

6. Verfahren nach einem der Ansprüche 3 bis 5, **dadurch gekennzeichnet, daß** in einem Zustand, in dem Verkehrsfunkinformationen vorrangig hörbar gemacht werden, die Überprüfung anderer Sendefrequenzen immer nur kurzzeitig unter jeweiligem Zurückspringen auf die ursprünglich eingestellte Sendefrequenz zur Überprüfung der eventuellen Aussendung eines Verkehrsfunkinformationskennungssignals vorgenommen wird.

7. Verfahren nach einem der Ansprüche 1 bis 6, **dadurch gekennzeichnet, daß** eine Überprüfung zeitgesteuert veranlaßt wird, wenn ein hierfür geeigneter Zustand des Autoradios vorliegt.

8. Autoradio, geeignet zur Durchführung des Verfahrens nach einem der Ansprüche 1 bis 7, mit einer abstimmbaren Empfängerstufe (2) und einer auf die Empfängerstufe (2) oder alternative Audioquellen (9) umschaltbaren Audiostufe (8), einer Steuerung (4) und einer Dekodierstufe (5) für Senderinformationen, an die ein Speicher (11) für verschiedene, zu einer Senderstation gehörende Sendefrequenzen angeschlossen ist, **dadurch gekennzeichnet, daß** die Steuerung (4) eine Statuskennung für den Ein- bzw. Ausschaltzustand des Autoradios und eine Statuskennung für eine Umschalteinrichtung (7) zwischen Empfängerstufe (2) und Audiostufe (8) aufweist und daß die Steuerung in Abhängigkeit von den Statuskennungen eine Durchstimmung der Empfängerstufe (2) zur Erkennung empfangbarer Sendefrequenzen und deren Zuordnung zu Senderstationen steuert.

## Claims

1. Method for checking and/or updating a stored transmitter table (S1...S8) for a car radio, in which transmitter information which is transmitted in a coded form by the radio broadcasting authorities within the broadcast radio signals is received and decoded, and two or more transmission frequencies which are associated with one transmitter station are stored in a memory (11), **characterized in that**, in a state of the car radio in which no broadcast radio programme has been selected as being audible, the car radio is tuned to various receivable transmission frequencies and, in the process, a check is carried out of the receivable transmitter stations and of the association with their various transmission frequencies and, if required, the transmission frequencies (S1...S8) that are stored in the memory (11) are refreshed or reorganized.

2. Method according to Claim 1, **characterized in that** the check of the receivable transmitter stations is carried out in the state in which the car radio has been switched off by the user.

3. Method according to Claim 1 or 2, **characterized in that** the check of the receivable transmitter stations is carried out while the equipment's own audio source (9), as an alternative, is audible.

4. Method according to one of Claims 1 to 3, **characterized in that** the check is dependent on a supply voltage (UZ) that is produced by the vehicle being detected.

5. Method according to one of Claims 1 to 4, **characterized in that** a check is carried out on switching off a supply voltage (UZ) which is produced by the vehicle.

6. Method according to one of Claims 3 to 5, **characterized in that**, in a state in which traffic radio information is made audible with priority, the check of other transmission frequencies is always carried out only for a short time, in each case jumping back to the originally selected transmission frequency, in order to check for the possible transmission of a traffic radio information identification signal.

7. Method according to one of Claims 1 to 6, **characterized in that** a check is initiated on a time-controlled basis when a state of the car radio that is suitable for this purpose exists.

8. Car radio, suitable for carrying out the method according to one of Claims 1 to 7, having a tunable receiver stage (2) and having an audio stage (8) which can be switched to the receiver stage (2) or to alternative audio sources (9), having a controller (4) and having a decoding stage (5) for transmitter information, to which a memory (11) for various transmission frequencies which are associated with a transmitter station is connected, **characterized in that** the controller (4) has a status identification for the car radio being in the switched-on or switched-off state, and has a status identification for a switching device (7) between a receiver stage (2) and an audio stage (8) and **in that** the controller controls the tuning of the receiver stage (2), in order to identify receivable transmission frequencies and their association with transmitter stations, as a function of the status identifications.

## Revendications

1. Procédé pour vérifier et/ou pour mettre à jour une table d'émetteurs (S1, ..., S8) mémorisée d'un autoradio, d'après lequel des informations d'émission émises sous forme codée dans les signaux radio par les organisations de radiodiffusion sont reçues et décodées et plusieurs fréquences d'émission correspondant à une station émettrice sont enregistrées dans une mémoire (11),
**caractérisé en ce que**
lorsque l'autoradio est dans un état où il ne reçoit pas de programme radio audible, l'autoradio est accordé sur différentes fréquences d'émission recevables et les stations émettrices recevables sont alors vérifiées et leurs différentes fréquences d'émission sont associées, et le cas échéant les fréquences d'émission (S1, ..., S8) enregistrées dans la mémoire (11) sont renouvelées ou reclassées.

2. Procédé selon la revendication 1,
**caractérisé en ce que**
la vérification des stations émettrices recevables a lieu lorsque l'utilisateur a déconnecté l'autoradio.

3. Procédé selon la revendication 1 ou 2,
**caractérisé en ce que**
la vérification des stations émettrices recevables est effectuée pendant qu'une autre source audio (9) propre peut être entendue.

4. Procédé selon l'une des revendications 1 à 3,
**caractérisé en ce que**
la vérification suppose qu'une tension d'alimentation (UZ) produite par le véhicule soit détectée.

5. Procédé selon l'une des revendications 1 à 4,
**caractérisé en ce que**
une vérification a lieu lorsqu'on déconnecte une tension d'alimentation (UZ) produite par le véhicule.

6. Procédé selon l'une des revendications 3 à 5,
**caractérisé en ce que**
dans un état où des informations de radioguidage routier ont une priorité d'audition, la vérification d'autres fréquences d'émission est toujours seulement de courte durée, en revenant à chaque fois à la fréquence d'émission réglée à l'origine pour vérifier si un signal d'information de radioguidage routier est éventuellement émis.

7. Procédé selon l'une des revendications 1 à 6,
**caractérisé en ce que**
une vérification est autorisée chronologiquement lorsque l'autoradio est dans un état adapté pour cela.

8. Autoradio adapté à exécuter le procédé selon l'une des revendications 1 à 7, comportant un étage de réception (2) susceptible d'être accordé et un étage audio (8) qu'on peut basculer sur l'étage de réception (2) ou sur une autre source audio (9), une commande (4) et un étage de décodage (5), destiné à des informations d'émission et auquel est raccordée une mémoire (11) pour différentes fréquences d'émission correspondant à une station émettrice,
**caractérisé en ce que**
la commande (4) comprend une caractéristique de statut qui reconnaît que l'autoradio est en état connecté ou déconnecté et une caractéristique de statut pour une installation de basculement (7) entre l'étage de réception (2) et l'étage audio (8), et
en fonction des caractéristiques de statut, elle commande d'ajuster l'étage de réception (2) pour reconnaître les fréquences d'émission recevables et pour les associer aux stations émettrices.
